(19) Europäisches Patentamt
European Patent Office
Office européen des brevets

(11) EP 4 718 094 A1

(12) EUROPEAN PATENT APPLICATION

(43) Date of publication:
01.04.2026 Bulletin 2026/14

(21) Application number: 25204799.8

(22) Date of filing: 25.09.2025

(51) International Patent Classification (IPC):
G01R 31/367 (2019.01)     G01R 31/389 (2019.01)
G01R 31/382 (2019.01)     G01R 31/3828 (2019.01)
G01R 31/374 (2019.01)

(52) Cooperative Patent Classification (CPC):
G01R 31/389; G01R 31/367; H01M 10/425;
H01M 10/48; H01M 10/486; G01R 31/374;
G01R 31/382; G01R 31/3828; H01M 2010/4271

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 26.09.2024 US 202418896907

(71) Applicant: MEDIATEK INC.
Hsinchu City 30078 (TW)

(72) Inventors:
• CHEN, Kuan-Yu
30078 Hsinchu City (TW)

• CHUANG, Jia-You
30078 Hsinchu City (TW)
• HSIEH, Ting-Hsiang
30078 Hsinchu City (TW)
• WU, Jui-Chi
30078 Hsinchu City (TW)
• LIAO, Chi-Cheng
30078 Hsinchu City (TW)

(74) Representative: Haseltine Lake Kempner LLP
Cheapside House
138 Cheapside
London EC2V 6BJ (GB)

(54) BATTERY POWER COMPUTING METHOD AND ELECTRONIC DEVICE USING THE BATTERY POWER COMPUTING METHOD

(57) A battery power computing method, applied to a battery and a corresponding electronic device (100), the electronic device comprising:
a battery (101); and
a processing circuit (103), configured to perform following steps:
acquiring a battery resistance table of the battery (101), wherein the battery resistance table comprises first mapping relations between a plurality of battery resistances of the battery (101) and a plurality of battery power levels;
acquiring a resistance conversion table, wherein the resistance conversion table comprises second mapping relations between a plurality of battery resistance conversions and a plurality of conditions of the battery (101); and
measuring the battery power according to the first mapping relations and the second mapping relations, while charging or discharging the battery (101).

FIG. 1

# EP 4 718 094 A1

**Description**

BACKGROUND

The present application relates to a battery power computing method and an electronic device using the method, and particularly relates to a battery power computing method and an electronic device which can calibrate the battery resistance variation.

The battery resistance may be affected by various factors. For example, as the usage time increases, the battery gradually degrades. However, the degradation of the battery may cause the battery to have a larger battery resistance. If the battery resistance is larger, the maximum battery usage time is correspondingly reduced. The variation of the battery resistance may affect the battery power computation. However, in related technique field, no proper battery power computing method which can improve such problem is provided.

SUMMARY

One objective of the present invention is to provide a battery power computing method which can calibrate the battery resistance variation caused by battery conditions.

Another objective of the present invention is to provide an electronic device which can calibrate the battery resistance variation caused by battery conditions.

One embodiment of the present application provides a battery power computing method, applied to a battery, comprising: acquiring a battery resistance table of the battery, wherein the battery resistance table comprises first mapping relations between a plurality of battery resistances of the battery and a plurality of battery power levels; acquiring a resistance conversion table, wherein the resistance conversion table comprises second mapping relations between a plurality of battery resistance conversions and a plurality of conditions of the battery; and measuring the battery power according to the first mapping relations and the second mapping relations, while charging or discharging the battery.

Another embodiment of the present application provides an electronic device with a battery and a processing circuit. The processing circuit is configured to perform following steps: acquiring a battery resistance table of the battery, wherein the battery resistance table comprises first mapping relations between a plurality of battery resistances of the battery and a plurality of battery power levels; acquiring a resistance conversion table, wherein the resistance conversion table comprises second mapping relations between a plurality of battery resistance conversions and a plurality of conditions of the battery; and measuring the battery power according to the first mapping relations and the second mapping relations, while charging or discharging the battery.

In view of above-mentioned embodiments, the battery resistances acquired from the battery resistance table can be calibrated, thereby the charging control and the discharging control of the battery may be more accurate.

These and other objectives of the present invention will no doubt become obvious to those of ordinary skill in the art after reading the following detailed description of the preferred embodiment that is illustrated in the various figures and drawings.

BRIEF DESCRIPTION OF THE DRAWINGS

FIG.1 is a block diagram illustrating an electronic device according to one embodiment of the present application.

FIG.2 and FIG.3 are schematic diagrams illustrating a battery resistance measuring method according to one embodiment of the present application.

FIG.4 is a block diagram illustrating an electronic device according to another embodiment of the present application.

FIG.5 is a schematic diagram illustrating a resistance conversion table according to one embodiment of the present application.

FIG.6 is a schematic diagram illustrating a resistance conversion table according to another embodiment of the present application.

FIG.7 is a schematic diagram illustrating a charging curve without resistance conversion and a charging curve with a resistance conversion, according to one embodiment of the present application.

FIG.8 is a schematic diagram illustrating a discharging curve without resistance conversion and a discharging curve with a resistance conversion, according to one embodiment of the present application.

FIG.9 is a flow chart illustrating a battery power computing method, according to one embodiment of the present application.

DETAILED DESCRIPTION

In the following descriptions, several embodiments are provided to explain the concept of the present application. It will be appreciated that the system, the device, the apparatus or the module depicted in following embodiments can be implemented by hardware (ex. circuit) or the combination of hardware and software (ex. a processing unit executing at least one program). The term "first", "second", "third" in following descriptions are only for the purpose of distinguishing different one elements, and do not mean the sequence of the elements. For example, a first device and a second device only mean these devices can have the same structure but are different devices.

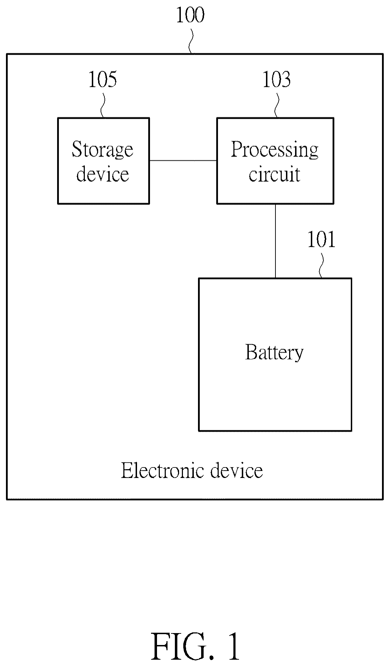

FIG.1 is a block diagram illustrating an electronic device 100 according to one embodiment of the present application. The electronic device 100 can be, for example, a mobile electronic device or a desktop computer. The mobile electronic device can be, for example, a mobile phone, a plate computer or a smart watch. As shown in FIG.1, the electronic device 100 comprises a battery 101, a processing circuit 103 and a storage device 105. The processing circuit 103 acquires a charge variation of the battery 101 for a measuring time interval (for the convenience of explaining, such step is named step (a) in the following). Also, the processing circuit 103 acquires a voltage difference between a first battery voltage and a second battery voltage for the measuring time interval, wherein the first battery voltage is a battery voltage with loading and the second battery voltage is a battery voltage without loading (for the convenience of explaining, such step is named step (b) in the following). Besides, the processing circuit 103 computes a battery resistance according to the charge variation and the voltage difference, and updates the battery resistance to a battery resistance table of the battery 101 (for the convenience of explaining, such step is named step (c) in the following). Details of the steps (a), (b) and (c) will be described in following descriptions.

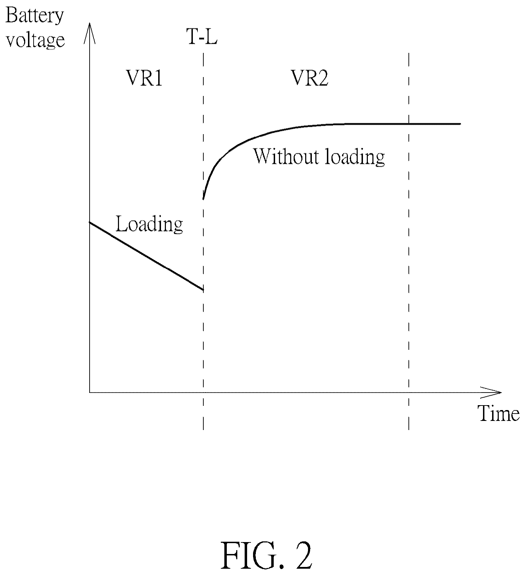

FIG.2, FIG.3 and FIG.4 are schematic diagrams illustrating a battery resistance measuring method according to one embodiment of the present application. Specifically, FIG.2 is a schematic diagram illustrating the battery voltage with loading and the battery voltage without loading (step (b)). In the region VR1 of FIG.2, the battery voltage is a battery voltage with loading. In one embodiment, the battery voltage with loading means the battery voltage when the electronic device with the battery is active or is using some applications. For example, the battery voltage with loading means the battery voltage when a mobile phone with the battery is active, or is making a phone call, or is playing a game. In such state, the battery voltage gradually goes down since the electronic device continuously consuming the power provided by the battery.

On the contrary, in the region VR2, the battery voltage without loading means the battery voltage when the electronic device with the battery is in a non-active state or in a sleep state. As shown in FIG.2, after the loading is released at the time T_L, the battery recovers to a stable value. For more detail, in one embodiment, after the loading is released at the time T_L, the battery voltage rises up quickly and then slowly increases, and keeps at a stable value finally. In following embodiments, the second voltage means a battery voltage without loading in a stable state.

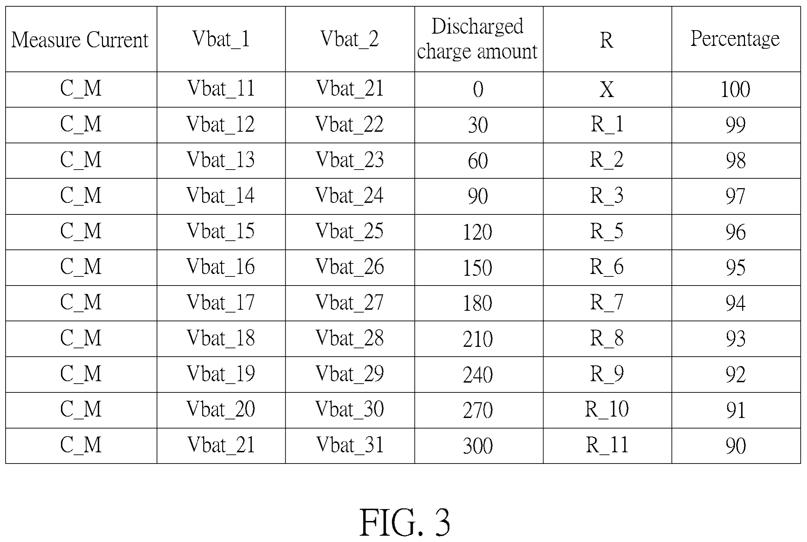

FIG.3 is a schematic diagram illustrating a battery resistance table. In FIG.3, the measure current C_M means the current which is drained from the battery for each battery resistance measurement. In one embodiment, a current value of the measure current C_M is 400 mA, but not limited. Also, the first battery voltage Vbat_1 is the above-mentioned first battery voltage, which is the battery voltage with loading. Further, the second battery voltage Vbat_2 is the above-mentioned second battery voltage, which is the battery voltage without loading. The discharged charge amount means the total charge which the battery has provided. In the embodiment of FIG.3, the measurement unit of the discharged charge amount is mAh (mA per hour), and each time of battery resistance measurement causes 30 mAh of the discharged charge amount, but not limited. The parameter R means the battery resistance. Moreover, the percentage means how much power of the battery remains.

In the first time of battery resistance measurement, the battery does not provide any power yet, thus the battery has 100% of power, and the first battery voltage Vbat_11, second battery voltage Vbat_21 are identical. In such case, the battery resistance is ignored since it may be infinite since the first battery voltage Vbat_11, second battery voltage Vbat_21 are identical. In the second time of battery resistance measurement, the battery has provided 30mAh of discharged charge, thus the battery power decreases to 99%. In such case, the battery resistance R_1 can be acquired by

$$\frac{(Vbat_{12} - Vbat_{22})}{C\_M}$$ . Following the same rule, in the third time of battery resistance measurement, the battery has provided 60mAh of discharged charge, thus the battery power decreases to 98%. In such case, the battery resistance R_2 can be acquired by $\frac{(Vbat_{13} - Vbat_{23})}{C\_M}$ . Such steps can be repeated, until a required battery resistance table is built.

The steps (a), (b), (c) described in the context to FIG.1 may correspond to the steps described in the context of FIG.3. For example, the step (a)acquires charge variation of the battery for a measuring time interval. The measuring time interval means a time interval for one time of battery resistance measurement. The charge variation may mean the discharged charge amount for each time of the battery resistance measurement, for example, the 30mAh for each time of the battery resistance measurement in FIG.1. Also, the step (b)acquires a voltage difference between a first battery voltage and a second battery voltage for the measuring time interval, and the step (c) computes a battery resistance according to the charge variation and the voltage difference, and updates the battery resistance to a battery resistance table of the battery. For example, in the second time of battery resistance measurement of FIG.3, the battery has provided 30mAh of discharged charge, and the battery resistance R_1 can be acquired by $\frac{(Vbat_{12}-Vbat_{22})}{C\_M}$ .

In view of above-mentioned descriptions, the following Equation (1) can be acquired

```
Equation (1):
```

$$\text{T} \times \frac{Va}{R} = Car$$

T means the measuring time interval in the step (a), which can be a fixed value. Car means the charge variation in the step (a), Va means the voltage difference in the step (b), and R means the batter resistance.

Based on the Equation (1), the Equation (2) for measuring a battery resistance can be acquired:

```
Equation (2)
```

$$\text{T} \times \frac{Va}{Car} = R$$

As above-mentioned, the steps of measuring the battery resistance may be repeated for a plurality of times to accomplish the battery resistance table. Therefore, the equation of the battery resistance in the battery resistance table can be represented as:

```
Equation (3)
```

$$\text{R\_i} = \text{T} \times \frac{Va\_i}{Car\_i}$$

i means the battery is measured for the i-th time. For example, in the embodiment of FIG.3, if i=1, the battery resistance is ignored since the battery resistance is infinite. If i=2, the measured battery resistance is the battery resistance R_1. If i=3, the measured battery resistance is the battery resistance R_2.

Please refer to FIG.1 again, in the embodiment of FIG.1, the charge variation Car is acquired by a coulomb counting method. Specifically, the processing circuit 103 executes at least one program in the storage device 105 to perform the coulomb counting method. However, the charge variation Car can be measured by a hardware.

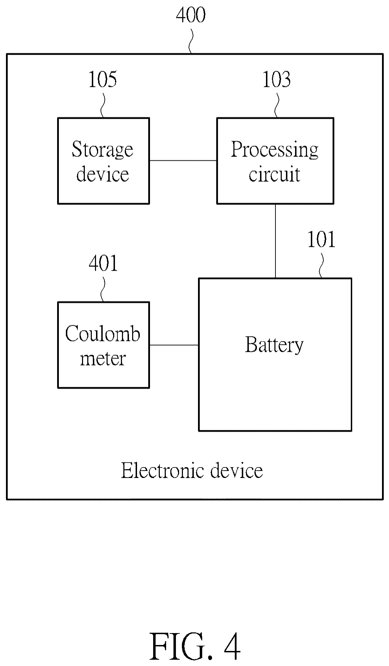

FIG.4 is a block diagram illustrating an electronic device 400 according to one embodiment of the present application. The electronic device 400 can be, for example, a mobile electronic device or a desktop computer. As shown in FIG.4, the electronic device 400 comprises a battery 101, a processing circuit 103, a storage device 105 and a coulomb meter 401. The coulomb meter 401 is a hardware and can provide a more accurate charge variation. The processing circuit 103 acquires a charge variation of the battery 101 for a measuring time interval (step (a)) via the coulomb meter 401. Also, the processing circuit 103 acquires a voltage difference between a first battery voltage and a second battery voltage for the measuring time interval, wherein the first battery voltage is a battery voltage with loading and the second battery voltage is a battery voltage without loading (step (b)). Besides, the processing circuit 103 computes a battery resistance according to the charge variation and the voltage difference, and updates the battery resistance to a battery resistance table of the battery 101 (step (c)).

In related art, the battery resistance table is built by a specific measurement equipment before selling the battery to the user. Such battery resistance table is fixed since the user does not have the specific measurement equipment for measuring the battery resistance. However, based on the embodiments of FIG.1 and FIG.4, the user can measure the battery resistance by the electronic device and no specific measurement equipment is needed. Accordingly, the battery resistance table can be updated in real time to meet a real condition of the battery.

In one embodiment, the battery has only one battery resistance table which is periodically updated, to make sure the battery resistance table meets the real condition of the battery.

The above-mentioned battery resistances may be used to compute the battery power. For example, if the battery receives a current (i.e., being charged) with a current amount (charge amount) I in a time interval Ti when the battery power is Q1 and the battery voltage is Vb, a new battery power Q2 can be computed by following Equation (4)

Equation (4)

$$Q2 = Q1 + I \times Ti = Q1 + \frac{Vb}{R} \times Ti$$

On the contrary, if the battery outputs a current (i.e., being discharged) with a current amount I in a time interval Ti when the battery power is Q1 and the battery voltage is Vb, a new battery voltage Q2 can be computed by following Equation (5)

Equation (5)

$$Q2 = Q1 - I \times Ti = Q1 - \frac{Vb}{R} \times Ti$$

The value of R , which means the battery resistance, may be dependent on the battery power level. For example, in the embodiment of FIG.3, if the battery power level is that the battery has 97% power, the battery resistance is R_3. For another example, if the battery power level is that the battery has 91% power, the battery resistance is R_10. However, the battery resistance may be affected by battery conditions. For example, the battery resistance of the battery with 97% power is R_3' rather than R_3. However, the new battery power Q2 is still computed based on the battery resistance R_3 rather than the real battery resistance R_3'. In such case, a wrong new battery power Q2 will be computed. Accordingly, in one embodiment, the present application further provides a resistance conversion table to improve such issue.

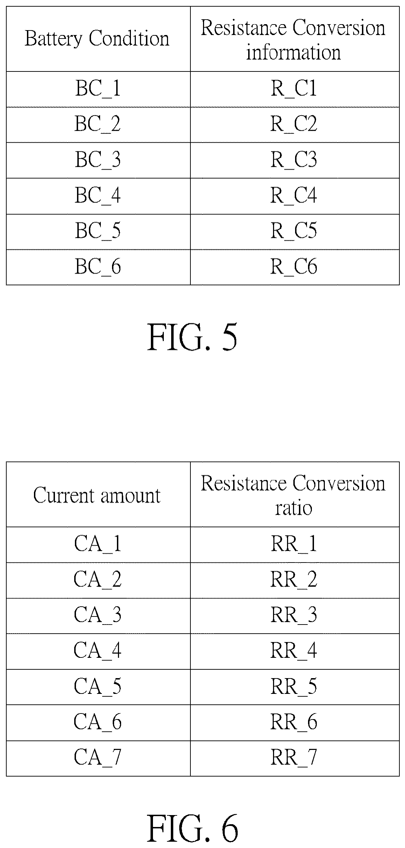

FIG.5 is a schematic diagram illustrating a resistance conversion table according to one embodiment of the present application. As shown in FIG.5, the resistance conversion table comprises battery conditions BC_1...BC_6, and resistance conversion information RC_1...RC_6. The resistance conversion information RC_1...RC_6 may comprise converted battery resistances which have been converted from the battery resistances recorded in the battery resistance table, or comprise the conversion parameters for converting the battery resistances. In the embodiment of FIG.5, the resistance conversion information RC_1...RC_6 are the converted battery resistances.

The battery resistance in the Equations (4) and (5) may be calibrated using one of the resistance conversion information RC_1...RC_6 corresponding to different battery conditions. For example, if the battery condition is BC_1 and the battery receives a current with a current amount I in a time interval Ti when the battery power is Q1 and the battery voltage is Vb, the Equation (4) is changed to:

Equation (6)

$$Q2 = Q1 + I \times Ti = Q1 + \frac{Vb}{R\_C1} \times Ti$$

Similarly, if the battery condition is BC_4 and the battery outputs a current with a current amount I in a time interval Ti when the battery power is Q1 and the battery voltage is Vb, the Equation (5) is changed to:

Equation (7)

$$Q2 = Q1 - I \times Ti = Q1 - \frac{Vb}{R\_C4} \times Ti$$

The types of battery conditions and the resistance conversion information may be selected corresponding to different requirements or designs. In one embodiment, the battery conditions exclude the battery power levels (e.g., percentages of battery power illustrated in FIG.3), since the relations between the battery resistances and battery conditions are comprised in the battery resistance table. In such case, the battery conditions may be, for example, temperatures or any other condition which is not the battery power level. In one embodiment, the battery conditions are current amounts of currents flowing into or out of the battery within a predetermined time interval. Further, in one embodiment, the resistance conversion information comprises resistance conversion ratios.

FIG.6 is a schematic diagram illustrating a resistance conversion table according to another embodiment of the present application. In the embodiment of FIG.6, the battery conditions are current amounts CA_1...CA_6 of currents flowing into or out of the battery within a predetermined time interval. The predetermined time interval may be the above-mentioned time interval Ti. Also, the resistance conversion information comprises resistance conversion ratios RR_1...RR_6.

Following the example illustrated in FIG.6, if the current amount is CA_1 and the battery receives a current with a current amount I in a time interval Ti when the battery power is Q1 and the battery voltage is Vb, the Equation (4) is changed to:

$$\text{Equation (8)}$$

$$Q2 = Q1 + I \times Ti = Q1 + \frac{Vb}{R \times RR\_1} \times Ti$$

Similarly, if the current amount is CA_4 and the battery outputs a current with a current amount I in a time interval Ti when the battery power is Q1 and the battery voltage is Vb, the Equation (5) is changed to:

$$\text{Equation (9)}$$

$$Q2 = Q1 - I \times Ti = Q1 - \frac{Vb}{R \times RR\_4} \times Ti$$

Please note, the numbers of battery conditions, the numbers of the resistance conversion information and the format of resistance conversion table are not limited to the embodiments of FIG.5 and FIG.6.

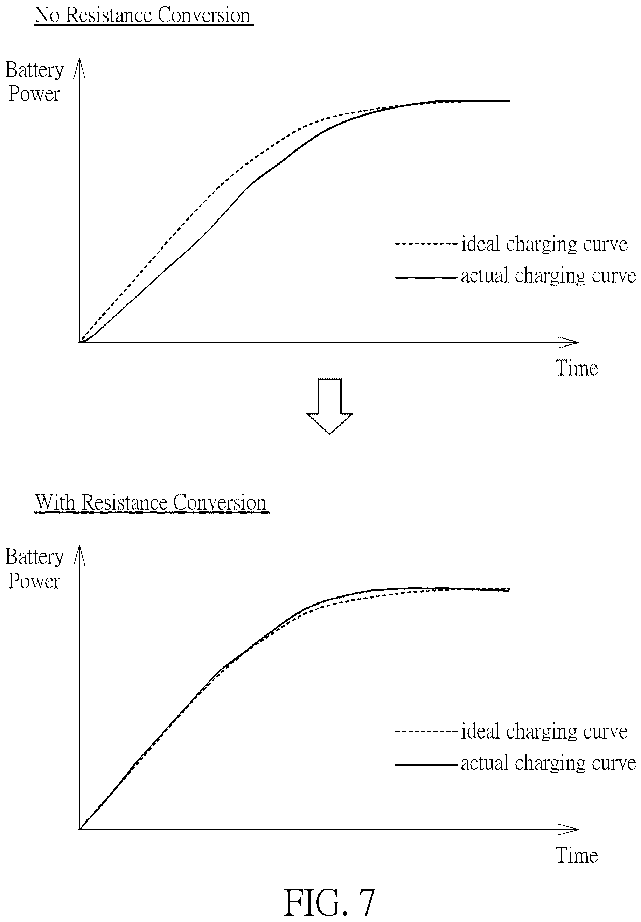

FIG.7 is a schematic diagram illustrating a charging curve without resistance conversion and a charging curve with a resistance conversion, according to one embodiment of the present application. The charging curve means the computed variation of the battery power while the battery is continuously charged. In FIG.7, the ideal charging curve may be generated by repeatedly using the rule stated in Equation (4). In other words, the ideal charging curve is one where no change in battery resistance due to battery conditions is expected to occur. On the contrary, the actual charging curve is a curve which means the real charging condition, thus is computed based on the actual battery resistances which are different from the battery resistances recorded in the battery resistance table. In the embodiment of FIG.7, the resistance variations are caused by the currents flowing into the battery, such as the embodiment shown in FIG.6.

Accordingly, in the upper diagram of FIG.7, a large difference between the actual charging curve and the ideal charging curve exists. Such difference may cause errors of charging control of the battery. In the lower diagram, the difference between the actual charging curve and the ideal charging curve is reduced, since the actual charging curve is computed according to the converted battery resistances. In other words, the actual charging curve in the lower diagram of FIG.7 is computed by repeatedly using the rule stated in the above-mentioned Equation (8). By this way, the charging control may be more accurate.

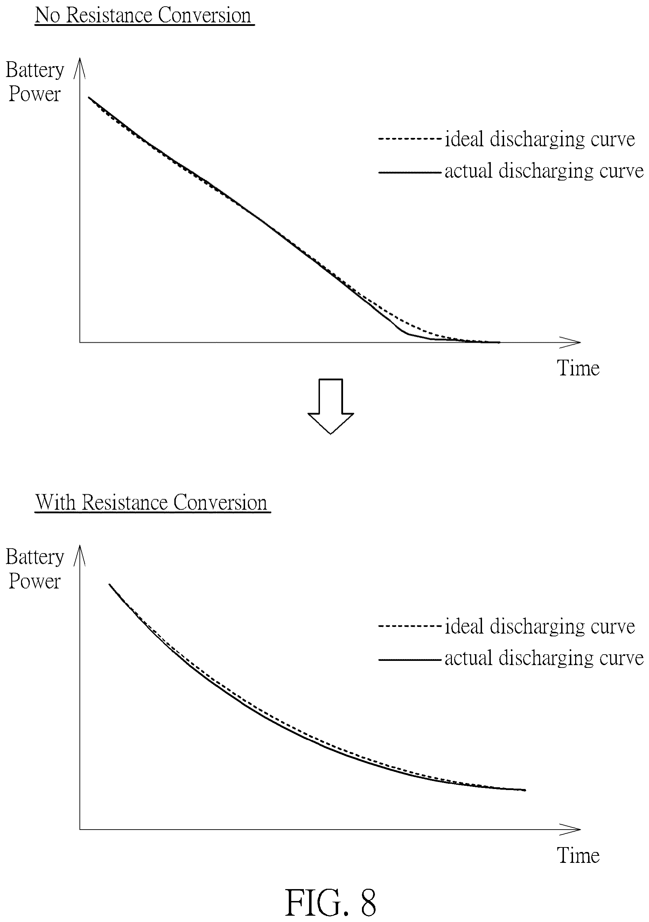

FIG.8 is a schematic diagram illustrating a discharging curve without resistance conversion and a discharging curve with a resistance conversion, according to one embodiment of the present application. The discharging curve means the computed variation of the battery power while the battery is continuously discharged. In FIG.8, the ideal discharging curve may be generated by repeatedly using the rules stated in Equation (5). In other words, the ideal discharging curve is one where no change in battery resistance due to battery conditions is expected to occur. On the contrary, the actual discharging curve is a curve which means the real discharging condition, thus is computed based on the actual battery resistances which are different from the battery resistances recorded in the battery resistance table. In the embodiment of FIG.8, the resistance variations are caused by the currents flowing out the battery, such as the embodiment shown in FIG.6.

Accordingly, in the upper diagram of FIG.8, a large difference between the actual discharging curve and the ideal discharging curve exists. Such difference may cause errors of discharging control of the battery. In the lower diagram of FIG.8, the difference between the actual discharging curve and the ideal discharging curve is reduced, since the actual discharging curve is computed according to the converted battery resistances. In other words, the actual discharging curve in the lower diagram of FIG.8 is computed by repeatedly using the rules stated in Equation (9). By this way, the discharging control may be more accurate.

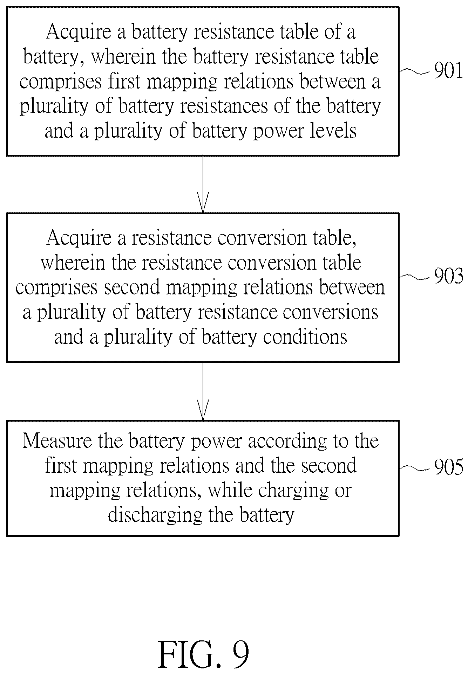

In view of above-mentioned embodiments, a battery power computing method can be acquired. FIG.9 is a flow chart illustrating a battery power computing method, according to one embodiment of the present application. The battery power computing method may be implemented by the electronic devices shown in FIG.1 or FIG.4, but not limited. The battery power computing method comprises following steps:

Step 901

Acquire a battery resistance table of a battery, wherein the battery resistance table comprises first mapping relations between a plurality of battery resistances of the battery and a plurality of battery power levels.

For example, in the embodiment of FIG.3, the battery resistance table comprises the first mapping relation between the battery resistance R_1 and the battery power level of 99% power, and the first mapping relation between the battery resistance R_2 and the battery power level of 98% power.

The battery resistance table may be generated by the embodiments illustrated in FIG.1-FIG.4, but may be acquired by other methods.

Step 903

Acquire a resistance conversion table, wherein the resistance conversion table comprises second mapping relations between a plurality of battery resistance conversions and a plurality of battery conditions.

For example, in the embodiment of FIG.5, the battery resistance table comprises the second mapping relation between the battery condition BC_1 and the conversion information R_C1, and the second mapping relation between the battery condition BC_2 and the conversion information R_C2.

In one embodiment, the resistance conversion table may be updated corresponding to different temperatures or different degradation levels of the battery. For example, if the battery operates in a temperature range Te_1-Te_2, the same resistance conversion table is used. If the battery operates in a temperature range Te_2-Te_3, the resistance conversion table is updated. Similarly, if the battery operates in a degradation level range De_1-De_2, the same resistance conversion table is used. If the battery operates in a degradation level range De_2-De_3, the resistance conversion table is updated.

In one embodiment, the resistance conversion table is generated by various testing and pre-recorded in an electronic device comprising the battery. In another embodiment, the second relations may be re-computed by the electronic device comprising the battery. Accordingly, the updating of the resistance conversion table may be performed by receiving updating information from outside of the electronic device. Alternatively, the updating information may be generated by the electronic device.

Step 905

Measure the battery power according to the first mapping relations and the second mapping relations, while charging or discharging the battery, such as the examples shown in FIG.7 and FIG.8.

Other detail steps can acquired according to above-mentioned embodiments, thus are omitted for brevity here.

In view of above-mentioned embodiments, the battery resistances acquired from the battery resistance table can be calibrated, thereby the charging control and the discharging control of the battery may be more accurate.

Those skilled in the art will readily observe that numerous modifications and alterations of the device and method may be made while retaining the teachings of the invention. Accordingly, the above disclosure should be construed as limited only by the metes and bounds of the appended claims.

Embodiments of the invention are set out in the following numbered clauses.

Clause 1. A battery power computing method, applied to a battery, comprising: acquiring a battery resistance table of the battery, wherein the battery resistance table comprises first mapping relations between a plurality of battery resistances of the battery and a plurality of battery power levels; acquiring a resistance conversion table, wherein the resistance conversion table comprises second mapping relations between a plurality of battery resistance conversions and a plurality of conditions of the battery; and measuring the battery power according to the first mapping relations and the second mapping relations, while charging or discharging the battery.

Clause 2. The battery power computing method of Clause 1, wherein the battery conditions exclude the battery power levels.

Clause 3. The battery power computing method of Clause 1, wherein the battery conditions are temperatures.

Clause 4. The battery power computing method of Clause 1, wherein the battery conditions are current amounts of currents flowing into or out of the battery within a predetermined time interval.

Clause 5. The battery power computing method of Clause 4, wherein the second mapping relations comprise relations between resistance conversion ratios of the battery resistances and the current amounts.

Clause 6. The battery power computing method of Clause 4, further comprising: updating the resistance conversion table corresponding to different temperatures or different degradation levels of the battery.

Clause 7. The battery resistance measuring method of Clause 4, wherein the battery has only one battery resistance table.

Clause 8. The battery power computing method of Clause 1, wherein the battery resistance table is generated by following steps: (a) acquiring charge variation of the battery for a measuring time interval; (b) acquiring a voltage difference between a first battery voltage and a second battery voltage for the measuring time interval, wherein the first battery voltage is a battery voltage with loading and the second battery voltage is a battery voltage without loading; and (c) computing a battery resistance according to the charge variation and the voltage difference, and updating the battery resistance to a battery resistance table of the battery.

Clause 9. The battery resistance measuring method of Clause 8, wherein the step (a) is performed by a coulomb meter which is hardware.

Clause 10. An electronic device, comprising: a battery; and a processing circuit, configured to perform following steps: acquiring a battery resistance table of the battery, wherein the battery resistance table comprises first mapping relations between a plurality of battery resistances of the battery and a plurality of battery power levels; acquiring a resistance conversion table, wherein the resistance conversion table comprises second mapping relations between a plurality of battery resistance conversions and a plurality of conditions of the battery; and measuring the battery power according to the first mapping relations and the second mapping relations, while charging or discharging the battery.

Clause 11. The electronic device of Clause 10, wherein the battery conditions exclude the battery power levels.

Clause 12. The electronic device of Clause 10, wherein the battery conditions are temperatures.

Clause 13. The electronic device of Clause 10, wherein the battery conditions are current amounts of currents flowing into or out of the battery within a predetermined time interval.

Clause 14. The electronic device of Clause 13, wherein the second mapping relations comprise relations between resistance conversion ratios of the battery resistances and the current amounts.

Clause 15. The electronic device of Clause 13, wherein the processing circuit further performs: updating the resistance conversion table corresponding to different temperatures or different degradation levels of the battery.

Clause 16. The electronic device of Clause 13, wherein the battery has only one battery resistance table.

Clause 17. The electronic device of Clause 10, wherein the battery resistance table is generated by following steps: (a) acquiring charge variation of the battery for a measuring time interval; (b) acquiring a voltage difference between a first battery voltage and a second battery voltage for the measuring time interval, wherein the first battery voltage is a battery voltage with loading and the second battery voltage is a battery voltage without loading; and (c) computing a battery resistance according to the charge variation and the voltage difference, and updating the battery resistance to a battery resistance table of the battery.

Clause 18. The electronic device of Clause 17, wherein the step (a) is performed by a coulomb meter which is hardware.

**Claims**

1. A battery power computing method, applied to a battery (101), comprising:

   acquiring (901) a battery resistance table of the battery (101), wherein the battery resistance table comprises first mapping relations between a plurality of battery resistances of the battery (101) and a plurality of battery power levels;

   acquiring (903) a resistance conversion table, wherein the resistance conversion table comprises second mapping relations between a plurality of battery resistance conversions and a plurality of conditions of the battery (101); and

   measuring (905) the battery power according to the first mapping relations and the second mapping relations, while charging or discharging the battery (101).

2. The battery power computing method of claim 1, wherein the battery conditions are temperatures or other conditions excluding the battery power levels.

3. The battery power computing method of claim 1, wherein the battery conditions are current amounts of currents flowing into or out of the battery (101) within a predetermined time interval.

4. The battery power computing method of claim 3, wherein the second mapping relations comprise relations between resistance conversion ratios of the battery resistances and the current amounts.

5. The battery power computing method of claim 3, further comprising:
updating the resistance conversion table corresponding to different temperatures or different degradation levels of the battery (101).

6. The battery resistance measuring method of claim 3, wherein the battery (101) has only one battery resistance table.

7. The battery power computing method of claim 1, wherein the battery resistance table is generated by following steps:

(a) acquiring charge variation of the battery (101) for a measuring time interval;
(b) acquiring a voltage difference between a first battery voltage and a second battery voltage for the measuring time interval, wherein the first battery voltage is a battery voltage with loading and the second battery voltage is a battery voltage without loading; and
(c) computing a battery resistance according to the charge variation and the voltage difference, and updating the battery resistance to a battery resistance table of the battery (101).

8. An electronic device (100), comprising:

a battery (101); and
a processing circuit (103), configured to perform following steps:

acquiring a battery resistance table of the battery (101), wherein the battery resistance table comprises first mapping relations between a plurality of battery resistances of the battery (101) and a plurality of battery power levels;
acquiring a resistance conversion table, wherein the resistance conversion table comprises second mapping relations between a plurality of battery resistance conversions and a plurality of conditions of the battery (101); and
measuring the battery power according to the first mapping relations and the second mapping relations, while charging or discharging the battery (101).

9. The electronic device (100) of claim 8, wherein the battery (101) conditions are temperatures or other conditions excluding the battery power levels.

10. The electronic device (100) of claim 8, wherein the battery conditions are current amounts of currents flowing into or out of the battery (101) within a predetermined time interval.

11. The electronic device (100) of claim 10, wherein the second mapping relations comprise relations between resistance conversion ratios of the battery resistances and the current amounts.

12. The electronic device (100) of claim 10, wherein the processing circuit (103) further performs:
updating the resistance conversion table corresponding to different temperatures or different degradation levels of the battery (101).

13. The electronic device (100) of claim 10, wherein the battery (101) has only one battery resistance table.

14. The electronic device (100) of claim 8, wherein the battery resistance table is generated by following steps:

(a) acquiring charge variation of the battery (101) for a measuring time interval;
(b) acquiring a voltage difference between a first battery voltage and a second battery voltage for the measuring time interval, wherein the first battery voltage is a battery voltage with loading and the second battery voltage is a battery voltage without loading; and

(c) computing a battery resistance according to the charge variation and the voltage difference, and updating the battery resistance to a battery resistance table of the battery (101).

15. The electronic device (100) of claim 14, wherein the step (a) is performed by a coulomb meter (401) which is hardware.

100

105 103

| Storage device | | Processing circuit |
|---|---|---|

101

Battery

Electronic device

FIG. 1

FIG. 2

| Measure Current | Vbat_1 | Vbat_2 | Discharged charge amount | R | Percentage |
|---|---|---|---|---|---|
| C_M | Vbat_11 | Vbat_21 | 0 | X | 100 |
| C_M | Vbat_12 | Vbat_22 | 30 | R_1 | 99 |
| C_M | Vbat_13 | Vbat_23 | 60 | R_2 | 98 |
| C_M | Vbat_14 | Vbat_24 | 90 | R_3 | 97 |
| C_M | Vbat_15 | Vbat_25 | 120 | R_5 | 96 |
| C_M | Vbat_16 | Vbat_26 | 150 | R_6 | 95 |
| C_M | Vbat_17 | Vbat_27 | 180 | R_7 | 94 |
| C_M | Vbat_18 | Vbat_28 | 210 | R_8 | 93 |
| C_M | Vbat_19 | Vbat_29 | 240 | R_9 | 92 |
| C_M | Vbat_20 | Vbat_30 | 270 | R_10 | 91 |
| C_M | Vbat_21 | Vbat_31 | 300 | R_11 | 90 |

FIG. 3

400

105                                                    103

| Storage device | | Processing circuit |

401                                                    101

| Coulomb meter | | Battery |

Electronic device

FIG. 4

| Battery Condition | Resistance Conversion information |
|---|---|
| BC_1 | R_C1 |
| BC_2 | R_C2 |
| BC_3 | R_C3 |
| BC_4 | R_C4 |
| BC_5 | R_C5 |
| BC_6 | R_C6 |

# FIG. 5

| Current amount | Resistance Conversion ratio |
|---|---|
| CA_1 | RR_1 |
| CA_2 | RR_2 |
| CA_3 | RR_3 |
| CA_4 | RR_4 |
| CA_5 | RR_5 |
| CA_6 | RR_6 |
| CA_7 | RR_7 |

# FIG. 6

No Resistance Conversion

Battery Power

ideal charging curve
actual charging curve

Time

With Resistance Conversion

Battery Power

ideal charging curve
actual charging curve

Time

FIG. 7

No Resistance Conversion

Battery
Power

- - - - - - - - ideal discharging curve
———— actual discharging curve

Time

With Resistance Conversion

Battery
Power

- - - - - - - - ideal discharging curve
———— actual discharging curve

Time

FIG. 8

Acquire a battery resistance table of a battery, wherein the battery resistance table comprises first mapping relations between a plurality of battery resistances of the battery and a plurality of battery power levels ~ 901

Acquire a resistance conversion table, wherein the resistance conversion table comprises second mapping relations between a plurality of battery resistance conversions and a plurality of battery conditions ~ 903

Measure the battery power according to the first mapping relations and the second mapping relations, while charging or discharging the battery ~ 905

FIG. 9

Europäisches
Patentamt

European
Patent Office

Office européen
des brevets

# EUROPEAN SEARCH REPORT

**Application Number**

EP 25 20 4799

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/138447 A1 (KO SEUNGTAE [KR] ET AL) 4 May 2023 (2023-05-04) * paragraph [0239] - paragraph [0298]; figures 20-28 * | 1-15 | INV. G01R31/367 G01R31/389 |
| A | US 2017/370995 A1 (HUANG XIAODONG [CN] ET AL) 28 December 2017 (2017-12-28) * paragraph [0012] - paragraph [0043]; figures 1-7 * | 1-15 | ADD. G01R31/382 G01R31/3828 G01R31/374 |
| A | US 2021/123980 A1 (KATAOKA TOMOMI [JP] ET AL) 29 April 2021 (2021-04-29) * the whole document * | 1-15 | |

**TECHNICAL FIELDS
SEARCHED (IPC)**

G01R
H01M

The present search report has been drawn up for all claims

| Place of search | Date of completion of the search | Examiner |
|---|---|---|
| Munich | 2 February 2026 | Hijazi, Ali |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 20 4799

This annex lists the patent family members relating to the patent documents cited in the above-mentioned European search report.
The members are as contained in the European Patent Office EDP file on
The European Patent Office is in no way liable for these particulars which are merely given for the purpose of information.

02-02-2026

| Patent document cited in search report | Publication date | Patent family member(s) | Publication date |
|---|---|---|---|
| US 2023138447 A1 | 04-05-2023 | AU 2022203328 A1 | 18-05-2023 |
| | | EP 4423871 A1 | 04-09-2024 |
| | | KR 20230064265 A | 10-05-2023 |
| | | US 2023138447 A1 | 04-05-2023 |
| | | WO 2023080334 A1 | 11-05-2023 |
| US 2017370995 A1 | 28-12-2017 | CN 106199434 A | 07-12-2016 |
| | | US 2017370995 A1 | 28-12-2017 |
| US 2021123980 A1 | 29-04-2021 | CN 112384814 A | 19-02-2021 |
| | | DE 112019003484 T5 | 08-04-2021 |
| | | JP WO2020012720 A1 | 12-08-2021 |
| | | US 2021123980 A1 | 29-04-2021 |
| | | WO 2020012720 A1 | 16-01-2020 |

EPO FORM P0459

For more details about this annex : see Official Journal of the European Patent Office, No. 12/82